# EUROPEAN PATENT APPLICATION

(11) **EP 4 610 667 A1**
(43) Date of publication of application: **03.09.2025**
(21) Application number: 24717565.6
(22) Date of filing: 01.02.2024
(51) Int. Cl.: G01R 1/067, G01R 3/00

(54) **METHOD FOR MANUFACTURING CONTACT TIP, AND ELECTRICALLY CONDUCTIVE PIN INCLUDING CONTACT TIP**

(30) Priority: 02.01.2024 KR 20240000560; 30.01.2024 KR 20240014344
(71) Applicant: Leeno Industrial Inc., Busan 46748 (KR)
(72) Inventor: BAEK, Seung Ha, Changwon-si, Gyeongsangnam-do 51608 (KR)
(74) Representative: Gulde & Partner
(86) International application number: PCT/KR2024/001527
(87) International publication number: WO 2025/146863

(57) **Abstract**

Proposed are a method for manufacturing a contact tip that can form a contact tip and an end portion into various shapes, and an electroconductive pin having a contact tip and an end portion of various shapes.

## Description

### Technical Field

The present disclosure relates generally to a method for manufacturing a contact tip and an electroconductive pin having a contact tip. More specifically, the present disclosure relates to a method for manufacturing a contact tip through cutting processing and an electroconductive pin having a contact tip manufactured through cutting processing.

### Background Art

An electroconductive pin refers to a pin that can be used in inspection devices such as probe cards and test sockets that makes contact with an inspection object and inspects the inspection object.

Inspection of semiconductor devices is performed by providing an electrical signal by bringing an inspection object, such as a semiconductor package or a semiconductor wafer, into contact with a test socket or probe card provided with a plurality of electroconductive pins.

Here, the electroconductive pin serves to transmit an electrical signal between the inspection object and the inspection device, and a contact tip is located at an end of the electroconductive pin and serves to transmit an electrical signal by making direct contact with the inspection device.

In this regard, Korean Patent Application Publication No. 10-2023-0119383 discloses a technology, entitled 'Pogo pin and method of fabricating the same'. The above patent describes a method of forming a groove having a shape corresponding to a contact tip on a surface of a sacrificial substrate and then filling it with a metal layer by plating to form a contact tip.

As such, the contact tip manufactured by an MEMS process has a limited shape. When etching the substrate with an etchant, the groove has a structure limited to a specific slope, specific depth, and specific shape depending on the crystal direction of the substrate.

That is, since the groove with a limited structure inevitably forms a contact tip with a limited structure (for example, square pyramid and truncated square pyramid structures), a problem arises in that it is impossible to respond to various environments.

### [Documents of Related Art]

### [Patent Documents]

(Patent Document 1) Korean Patent Application Publication No. 10-2023-0119383

### Disclosure

### Technical Problem

Accordingly, the present disclosure has been made keeping in mind the above problems occurring in the related art, and an objective of the present disclosure is to provide a method for manufacturing a contact tip that can form a contact tip and an end portion into various shapes.

Another objective of the present disclosure is to provide an electroconductive pin having a contact tip and an end portion of various shapes.

### Technical Solution

In order to accomplish the above objective, according to one aspect of the present disclosure, there is provided a method for manufacturing a contact tip used for an electroconductive pin for inspecting electrical properties of an inspection object, the method including: a preparation step of preparing a contact member to be processed; an end portion forming step of forming an end portion by cutting a longitudinal surface of the contact member; a flat portion forming step of cutting the longitudinal surface to form a flat surface to which the end portion is connected; and a contact tip forming step of forming an exterior of a contact tip by processing a side surface of the contact member.

In addition, in the end portion forming step, surfaces constituting the end portion may be subjected to mirror surface finishing.

In addition, in the end portion forming step, the end portion may be formed in the shape of a pyramid or cone.

In addition, in the end portion forming step, the end portion may include a plurality of end portions. Each end portion may have a pyramid shape, and each end portion may be formed so that at least one vertex thereof is in contact with an edge of the flat portion.

In addition, in the end portion forming step, the end portion may include a plurality of end portions spaced apart from each other.

In addition, in the contact tip forming step, a side surface of the flat portion may be processed so that an edge of the flat surface makes contact with the contact tip.

In addition, in the contact tip forming step, a side surface of the flat portion may be processed to remove a part of the contact tip on the flat surface.

In addition, the method may further include: a plating layer forming step of forming a plating layer on the contact tip.

Meanwhile, according to another aspect of the present disclosure, there is provided an electroconductive pin, including: a contact tip manufactured by the method; a barrel part having a side connected to the contact tip; an elastic part located in a hollow of the barrel part and having a side supported by the contact tip; and a moving tip moved in a longitudinal direction in conjunction with compression and extension of the elastic part.

In addition, the contact tip may include a single triangular pyramid-shaped end portion.

In addition, the contact tip may include a plurality of square pyramid-shaped end portions and a flat surface on which the plurality of end portions are formed. An edge of the flat surface may be in contact with the plurality of end portions.

In addition, the contact tip may include an end portion having a shape in which one vertex area is removed from a square pyramid shape and a flat surface on which the end portion is formed.

### Advantageous Effects

The present disclosure can provide a contact tip of various shapes by manufacturing a contact tip through processing, and adjusting the height of an end portion, the slope of the end portion, and the interval between end portions.

The present disclosure can provide an electroconductive pin of various shapes by forming a contact tip into various shapes through processing.

### Description of Drawings

FIG. 1 is a sectional view illustrating an electroconductive pin having a contact tip according to an embodiment of the present disclosure.
FIG. 2 is a flowchart illustrating a method for manufacturing a contact tip according to an embodiment of the present disclosure.
FIG. 3a is a view illustrating a contact tip including one square pyramid-shaped end portion in an embodiment of the present disclosure.
FIG. 3b is a view illustrating a contact tip including one triangular pyramid-shaped end portion in an embodiment of the present disclosure.
FIG. 3c is a view illustrating a contact tip including one cone-shaped end portion according to an embodiment of the present disclosure.
FIG. 4a is a view illustrating a plurality of end portions formed in non-contact with an edge of a flat surface in an embodiment of the present disclosure.
FIG. 4b is a view illustrating a plurality of end portions formed in contact with an edge of a flat surface in an embodiment of the present disclosure.
FIG. 4c is a view illustrating a plurality of end portions formed with a part of an end portion removed in an embodiment of the present disclosure.
FIG. 5 is a view illustrating a plated contact tip in an embodiment of the present disclosure.

### Mode for Invention

Those skilled in the art will be able to devise various devices which, although not explicitly described or illustrated herein, embody the principles of the present disclosure and fall within the concept and scope of the present disclosure. It is also to be understood that all conditional terms and embodiments described in this specification are, in principle, intended only for the purpose of enabling the inventive concept to be understood, and are not intended to limit the scope of the present disclosure to such specifically recited embodiments and conditions.

The above and other objectives, features, and advantages of the present disclosure will be more clearly understood from the following detailed description taken in conjunction with the accompanying drawings. Accordingly, those skilled in the art will readily understand the technical idea of the present disclosure from the detailed description.

The embodiments described herein will be described with reference to cross-sectional views and/or perspective views that are ideal illustrations of the present disclosure. The sizes of the configurations illustrated in the drawings are exaggerated for an effective description of the technical idea. As such, variations from the shapes of the illustrations as a result, for example, of manufacturing techniques and/or tolerances, are to be expected.

In describing various embodiments, the same functional elements are denoted by the same reference numerals throughout the embodiments. Further, the expression 'at least one of A, B, and C' means that one, two, or three of A, B, and C are provided. Further, a cross-section or cross-sectional area may mean a cross-section orthogonal to a longitudinal direction, unless otherwise specified. Further, the longitudinal direction may refer to the direction in which an elastic part 400 is extended and compressed. Furthermore, the configuration and operation already described in other embodiments will be omitted for convenience.

First, the structure of an electroconductive pin 10 having a contact tip 100 according to an embodiment of the present disclosure will be described.

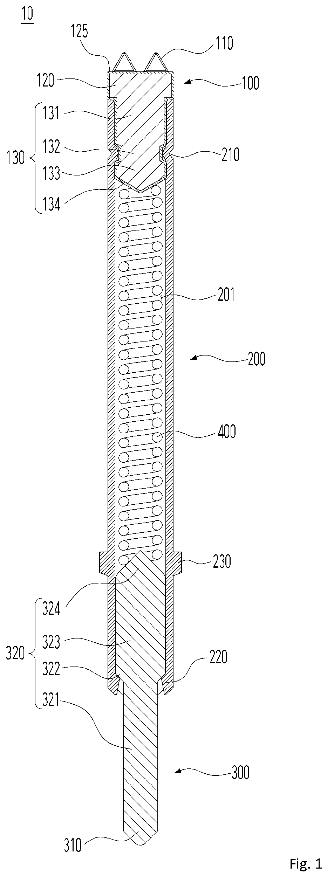

FIG. 1 is a view illustrating a section of the electroconductive pin 10 having the contact tip 100 according to the embodiment of the present disclosure.

Referring to FIG. 1, the electroconductive pin 10 according to the embodiment of the present disclosure may include: the contact tip 100; a barrel part 200 having a side connected to the contact tip 100; an elastic part 400 located in a hollow 201 of the barrel part 200 and having a side supported by the contact tip 100; and a moving tip 300 moved in the longitudinal direction in conjunction with compression and extension of the elastic part 400.

The contact tip 100 may make contact with an inspection object (not illustrated) and exchange electrical signals with the inspection object. The contact tip 100 may be partially located in the hollow 201 of the barrel part 200 and fixed to the barrel part 200.

The contact tip 100 may include an end portion 110, a flat portion 120 having a flat surface 125 in contact with a bottom surface of the end portion 110, and a body portion 130 extending in the longitudinal direction from the flat portion 120 and located in the hollow 201.

The contact tip 100 may be manufactured by a contact tip manufacturing method, which will be described later.

At least one end portion 110 may be provided. The end portion 110 may be provided to protrude from the flat surface 125 that forms one surface of the flat portion 120. The end portion 110 may be provided so that the cross-sectional area thereof gradually becomes small in the longitudinal direction. However, the shape of the end portion 110 is not limited to that described above.

The end portion 110 may be provided in the shape of one of a prism, a cylinder, a pyramid, a cone, a truncated pyramid, and a truncated cone. A plurality of end portions 110 may each be provided in the shape of one of a prism, a cylinder, a pyramid, a cone, a truncated pyramid, and a truncated cone. However, the shape of the end portions 110 is not limited to those described above. The plurality of end portions 110 may be provided on the flat surface 125 to be independently spaced apart from each other.

The contact tip 100 may include a single end portion 110 having a triangular pyramid shape, a polygonal pyramid shape, or a cone shape. The contact tip 100 may include a plurality of end portions 110 having a square pyramid shape, a polygonal pyramid shape, or a cone shape.

The contact tip 100 may include a flat portion 120 provided with a flat surface 125 on which a single or a plurality of end portions 110 are formed. The flat surface 125 may have an edge in contact with the plurality of end portions 110.

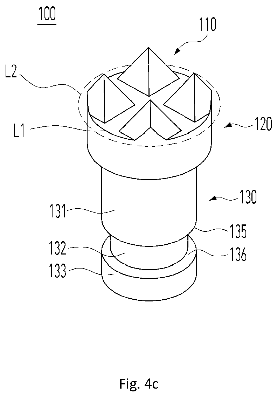

The contact tip 100 may include an end portion 110 in the shape of a square pyramid or a polygonal pyramid with one vertex area removed (see FIG. 4c). A removed surface of the end portion 110 from which one vertex area is removed may be formed to extend from the flat portion 120 while having the same curvature as a side surface of the flat portion 120.

The body portion 130 may have a smaller cross-sectional area than the flat portion 120. The body portion 130 may have the same central axis as the flat portion 120. The body portion 130 may include a first body portion 131, a second body portion 132, a third body portion 133, and a fourth body portion 134.

The first body portion 131 may extend from the flat portion 120 in the longitudinal direction. The first body portion 131 may have a smaller cross-sectional area than the flat portion 120.

The second body portion 132 may extend from the first body portion 131 in the longitudinal direction. The second body portion 132 may have a smaller cross-sectional area than the first body portion 131.

The third body portion 133 may extend from the second body portion 132 in the longitudinal direction. The third body portion 133 may have a larger cross-sectional area than the second body portion 132. The third body portion 133 may have the cross-sectional area as the first body portion 131.

The fourth body portion 134 may extend from the third body portion 133 in the longitudinal direction. The fourth body portion 134 may have a cross-sectional area that gradually becomes small in the longitudinal direction. The fourth body portion 134 may support the elastic part 400 in the longitudinal direction.

The first body portion 131 and the second body portion 132 may form a first step 135 due to a difference in the cross-sectional area. The second body portion 132 and the third body portion 133 may form a second step 136 due to a difference in the cross-sectional area. A first separation preventing portion 210 of the barrel part 200 may be located between the first step 135 and the second step 136 to prevent separation of the barrel part 200 and the contact tip 100.

The moving tip 300 may make contact with an inspection device (not illustrated) or an electric circuit (not illustrated) to exchange electric signals with the inspection device or the electric circuit.

The moving tip 300 may include a moving end portion 310 and a moving body portion 320.

The moving end portion 310 may be provided to extend from the moving body portion 320. The moving end portion 310 may be provided so that the cross-sectional area thereof gradually becomes small in the longitudinal direction. However, the shape of the moving end portion 310 is not limited to that described above.

The moving body portion 320 may include a first moving body portion 321, a second moving body portion 322, a third moving body portion 323, and a fourth moving body portion 324.

The first moving body portion 321 may extend from the moving end portion 310 in the longitudinal direction. As the elastic part 400 is compressed and extended, a part of the first moving body portion 321 may be moved in the longitudinal direction along the hollow 201 and the remaining part thereof may be moved in the longitudinal direction outside the hollow 201.

The second moving body portion 322 may extend from the first moving body portion 321 in the longitudinal direction. The second moving body portion 322 may have a cross-sectional area that gradually becomes large in the longitudinal direction.

The second moving body portion 322 may be located in the hollow 201 and may be moved in the longitudinal direction along the hollow 201 in conjunction with compression and extension of the elastic part 400. The second moving body portion 322 may have an outer surface in contact with an inner surface of a second separation preventing portion 220 of the barrel part 200 to prevent separation of the moving tip 300 from the barrel part 200.

The third moving body portion 323 may extend from the second moving body portion 322 in the longitudinal direction. The third moving body portion 323 may have a larger cross-sectional area than the first moving body portion 321.

The fourth moving body portion 324 may extend from the third moving body portion 323 in the longitudinal direction. The fourth moving body portion 324 may have a cross-sectional area that gradually becomes small in the longitudinal direction. The fourth moving body portion 324 may support the elastic part 400 in the longitudinal direction.

The barrel part 200 may have the hollow 201 and may accommodate the elastic part 400 through the hollow 201. The barrel part 200 may accommodate a part of the contact tip 100 in the hollow 201 and fix the contact tip 100. The barrel part 200 may accommodate a part of the moving tip 300 in the hollow 201 to provide a space for the moving tip 300 to be moved in the longitudinal direction.

The barrel part 200 may include the first separation preventing portion 210 and the second separation preventing portion 220. The first separation preventing portion 210 may be formed to be recessed in the central axis direction from a side surface of the barrel part 200 between opposite ends of the barrel part 200. The second separation preventing portion 220 may be formed to be bent in the central axis direction at an end of the barrel part 200.

The first separation preventing portion 210 may narrow the cross-sectional area of the hollow 201 to prevent the contact tip 100 from being separated from the barrel part 200. The second separation preventing portion 220 may narrow the cross-sectional area of the hollow 201 to prevent the moving tip 300 from being separated from the barrel part 200.

The barrel part 200 may include a fixing portion 230. The fixing portion 230 may be formed to protrude in the radial direction from an outer surface of the barrel part 200 between the opposite ends of the barrel part 200. The fixing portion 230 may be formed along the circumferential direction from the barrel part 200 and may have a larger outer diameter than other regions of the barrel part 200. The fixing portion 230 may fix the electroconductive pin 10 or the barrel part 200 within the inspection device.

The elastic part 400 may be located in the hollow 201 of the barrel part 200. The elastic part 400 may include a spring. The elastic part 400 may be compressed when the contact tip 100 makes contact with the inspection object and receives pressure. The elastic part 400 may be extended (restored) again when the contact between the contact tip 100 and the inspection object is released.

The elastic part 400 may have a first end supported by the contact tip 100 and/or the fourth body portion 134 in the longitudinal direction. The elastic part 400 may have a second end supported by the moving tip 300 and/or the fourth moving body portion 324 in the longitudinal direction.

The electroconductive pin 10 according to the embodiment of the present disclosure may include the contact tip 100, the moving tip 300, the barrel part 200, and the elastic part 400. The contact tip 100 and the barrel part 200 are independent configurations and may be coupled to each other to form the electroconductive pin 10.

In the electroconductive pin 10, the contact tip 100 and the barrel part 200 may be manufactured integrally as a single body to form the electroconductive pin 10. In this case, the contact tip 100 may include only the end portion 110, the flat surface 125, and the flat portion 120, and may be formed to extend integrally from an end of the barrel part 200.

In the electroconductive pin 10 according to the embodiment of the present disclosure, the elastic part 400 may be compressed when the contact tip 100 makes contact with the inspection object and receives pressure in the longitudinal direction, and the moving tip 300 may be moved in the longitudinal direction in conjunction with the compression of the elastic part 400.

In the electroconductive pin 10 according to the embodiment of the present disclosure, the elastic part 400 may be extended when the contact between the contact tip 100 and the inspection object is released, and the moving tip 300 may be moved in the longitudinal direction in conjunction with the extension of the elastic part 400.

Next, a method for manufacturing a contact tip according to an embodiment of the present disclosure will be described.

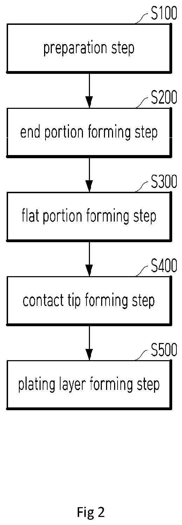

FIG. 2 is a flowchart illustrating the method for manufacturing the contact tip according to the embodiment of the present disclosure.

Referring to FIG. 2, the method for manufacturing the contact tip according to the embodiment of the present disclosure may include a preparation step S100 of preparing a contact member to be processed, an end portion forming step S200 of forming an end portion 110 by cutting a longitudinal surface of the contact member, a flat portion forming step S300 of cutting the longitudinal surface of the contact member to form a flat surface 125 to which the end portion 110 is connected, and a contact tip forming step S400 of forming the exterior of a contact tip 100 by processing a side surface of the contact member.

First, the preparation step S100 of preparing the contact member to be processed may be performed.

The contact member may refer to a state before the contact tip 100 is processed. When the contact tip 100 and a barrel part 200 are formed integrally, the contact member may refer to a state before the contact tip 100 and the barrel part 200 are processed.

The contact member may be formed in the shape of a cylinder or a prism, but is not limited thereto. The contact member may be processed by a cutting means such as a lathe, milling machine, machining center, drilling machine, or grinding machine. The contact member may include a hollow formed in at least a part of a longitudinal region by drilling.

Next, the end portion forming step S200 of forming the end portion 110 by cutting the longitudinal surface of the contact member, and the flat portion forming step S300 of forming the flat surface 125 to which the end portion 110 is connected by cutting the longitudinal surface of the contact member may be performed.

When the contact member has a column shape, the contact member may have at least one side surface and two bottom surfaces. Here, one of the bottom surfaces may be defined as a longitudinal surface, which will be described later.

The longitudinal surface of the contact member may be cut to form the end portion 110. The cutting means may cut the contact member to form the end portion 110 as it is moved relative to the contact member.

The end portion 110 may be formed in the shape of one of a triangular pyramid, a square pyramid, a cone, a truncated triangular pyramid, a truncated square pyramid, a truncated cone, a triangular prism, a square prism, and a cylinder. However, the shape of the end portion 110 is not limited to those described above.

Since the end portion 110 is formed by cutting, the end portion 110 may have various shapes without limitation in number, shape of the bottom surface, edge length of the bottom surface, radius of the bottom surface, shape of the side surface, edge length of the side surface, and the like. The surfaces constituting the end portion 110 may be subjected to mirror surface finishing.

The longitudinal surface of the contact member may be cut to form a flat portion 120. The cutting means may cut the contact member to form the flat portion 120 as it is moved relative to the contact member.

The flat portion 120 has the flat surface 125 on a first side thereof and may support the end portion 110. That is, the contact tip 100 may have a flat shape on a side thereof except for the end portion 110. The flat portion 120 may be formed to extend from a body portion 130 in the longitudinal direction.

The flat portion 120 may have a second side in contact with an end of the barrel part 200. In the contact state, a first separation preventing portion 210 may be located between a first step 135 and a second step 136 so that the contact tip 100 is coupled to the barrel part 200.

The end portion forming step S200 and the flat portion forming step S300 may be performed simultaneously. The cutting means may cut a part of the contact member to form the end portion 110 and simultaneously cut another part of the contact member to form the flat portion 120.

As a comparative example, according to an MEMS contact tip manufacturing method, the shape of a groove etched into a substrate is limited, so a contact tip 100 formed by plating the groove also has a limited shape.

Since the method for manufacturing the contact tip according to the embodiment of the present disclosure manufactures the contact tip 100 through cutting processing, the shape of the end portion 110 may be more freely implemented.

Next, the contact tip forming step S400 of forming the exterior of the contact tip 100 by processing the side surface of the contact member may be performed.

The side surface of the contact member may be cut to form the exterior of the contact tip 100. The contact member may be processed as the cutting means is moved along the circumference of the contact member, or the contact member may be processed by the cutting means as the contact member is rotated.

The side surface of the contact member may be cut and processed into the flat portion 120 and the body portion 130. Specifically, the side surface of the contact member may be cut and processed into the flat portion 120, a first body portion 131, a second body portion 132, a third body portion 133, and a fourth body portion 134.

The flat portion 120 may have a cross-section outer diameter the same as the outer diameter of the barrel part 200. The body portion 130 may have a cross-section outer diameter smaller than or the same as the inner diameter of the barrel part 200. The first body portion 131 may have a cross-section outer diameter smaller than that of the flat portion 120. The second body portion 132 may have a cross-section outer diameter smaller than that of the first body portion 131. The third body portion 133 may have a cross-section outer diameter larger than that of the second body portion 132. The fourth body portion 134 may have a cross-section outer diameter that gradually becomes small from the third body portion 133 in the longitudinal direction.

The first body portion 131 and the third body portion 133 may have the same cross-section outer diameter and may have an inner diameter the same as or smaller than that of the barrel part 200. The first separation preventing portion 210 may have an inner diameter smaller than the outer diameter of the first body portion 131 and the third body portion 133 and larger than the outer diameter of the second body portion 132.

As described above, the cutting means may process the flat portion 120 and the body portion 130 by cutting the side surface of the contact member.

The radius of the flat surface may be adjusted while cutting the side surface of the contact member. Depending on the degree of cutting of the side surface of the contact member, the outer diameter of the flat portion 120 and the radius of the flat surface 125 may be decreased. As the degree of cutting of the side surface of the contact member increases, an edge of the flat surface 125 may approach the end portion 110.

When the side surface of the contact member is cut along the central axis to a starting position of the end portion 110, the end portion 110 may make contact with the edge of the flat surface 125. Here, when the contact tip 100 is viewed in the longitudinal direction, the end portion 110 having a complete shape may appear in contact with the edge of the flat surface 125 of the flat portion 120.

When the side surface of the contact member is cut along the central axis to an inner position of the end portion 110, the end portion 110 may be partially removed and make contact with the edge of the flat surface 125. Here, when the contact tip 100 is viewed in the longitudinal direction, the end portion 110 having a shape in which a part thereof is removed may appear in contact with the edge of the flat surface 125 of the flat portion 120. That is, the end portion 110 may not protrude in the radial direction from the flat surface 125 of the flat portion 120, and when the contact tip 100 is viewed in the longitudinal direction, the shape of the contact tip 100 may be circular.

The contact tip forming step S400 may include a flat portion side surface forming step of forming a side surface of the flat portion 120 by processing the side surface of the contact member, and a body portion side surface forming step of forming a side surface of the body portion 130 by processing the side surface of the contact member.

In the flat portion side surface forming step, the side surface of the flat portion 120 of the contact member may be cut to reduce the area of the flat surface 125. In this process, the edge of the flat portion 120 may make contact with the end portion 110 that has already been formed.

In the flat portion side surface forming step, the side surface of the flat portion 120 of the contact member may be further cut to further reduce the area of the flat surface 125. In this process, a part of the flat portion 120 may be removed along with a part of the end portion 110 that has already been formed.

In the body portion side surface forming step, the side surface of the body portion 130 of the contact member may be cut so that each region of the body portion 130 (the first to fourth body portions 131 to 134) has the above-mentioned cross-sectional area or outer diameter.

Next, the shape of the contact tip 100 manufactured by the method for manufacturing the contact tip according to the embodiment of the present disclosure will be described.

In describing the contact tip 100, descriptions of the same content as described above will be omitted, and differences in configuration will be described.

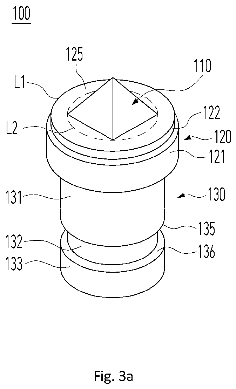

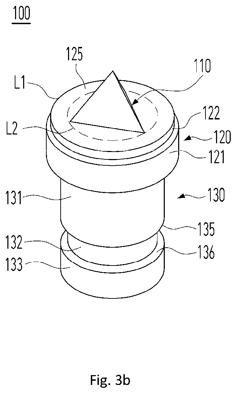

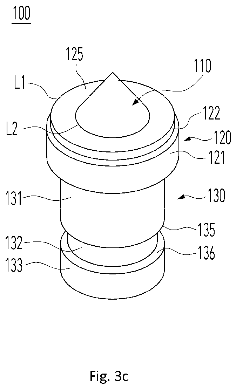

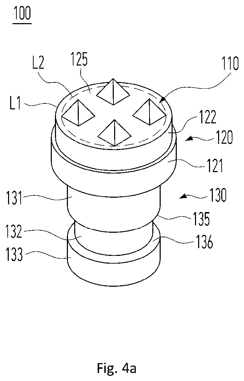

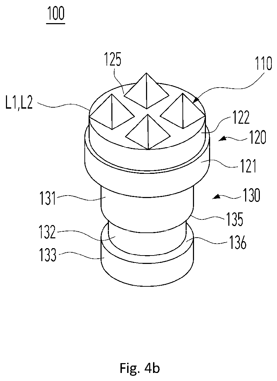

FIG. 3a is a view illustrating a contact tip 100 including one square pyramid-shaped end portion 110 in an embodiment of the present disclosure. FIG. 3b is a diagram showing a contact tip 100 including one triangular pyramid-shaped end portion 110 in an embodiment of the present disclosure. FIG. 3c is a view illustrating a contact tip 100 including one cone-shaped end portion 110 according to an embodiment of the present disclosure. FIG. 4a is a view illustrating a plurality of end portions 110 formed in non-contact with an edge of a flat surface 125 in an embodiment of the present disclosure. FIG. 4b is a view illustrating a plurality of end portions 110 formed in contact with an edge of a flat surface 125 in an embodiment of the present disclosure. FIG. 4c is a view illustrating a plurality of end portions 110 formed with a part of an end portion 110 removed in an embodiment of the present disclosure.

A first line L1 refers to an edge of a flat portion 120 or an edge of a flat surface 125. A second line L2 has the same shape as the first line L1, and refers to a virtual edge connecting the outermost points of at least one end portion 110 (when a part of the end portion 110 is removed, a complete shape before removal is taken as the reference shape).

Referring to FIG. 3a, a single end portion 110 may be formed on a flat portion 120. Here, the end portion 110 may have a square pyramid shape. A contact tip 100 according to an embodiment of the present disclosure may include an end portion 110, a flat portion 120, and a body portion 130.

In the end portion forming step S200 and the flat portion forming step S300, a contact member may be cut and processed into a single square pyramid-shaped end portion 110 and processed into a flat portion 120 including a flat surface 125 supporting the single end portion 110.

In the contact tip forming step S400, a side surface of the contact member may be processed to determine the cross-sectional area or outer diameter of the flat portion 120. Furthermore, the side surface of the contact member may be processed to determine the cross-sectional area or outer diameter of the body portion 130.

As illustrated in FIG. 3a, a first line L1 may be located outside a second line L2. On the other hand, the first line L1 may be located in the same position as the second line L2 (see FIG. 4b), or the first line L1 may be located inside the second line L2 (see FIG. 4c).

The flat portion 120 may include a first portion 121 and a second portion 122. The first portion 121 may be a region extending from the body portion 130 in the longitudinal direction. The second portion 122 may be a region extending from the first portion 121 in the longitudinal direction. The second portion 122 may have a smaller cross-sectional area or outer diameter than the first portion 121. The second portion 122 may include the flat surface 125 that supports the end portion 110.

In the contact tip forming step S400, the side surface of the contact member may be processed to form the second portion 122. The flat portion 120 is not necessarily formed by dividing into the first portion 121 and the second portion 122 having different cross-sectional areas or outer diameters. On the other hand, the flat portion 120 may be formed in a single shape with the same cross-sectional area or outer diameter.

Referring to FIG. 3b, a single end portion 110 may be formed on a flat portion 120. Here, the end portion 110 may have a triangular pyramid shape.

In the end portion forming step S200 and the flat portion forming step S300, a contact member may be cut and processed into a single triangular pyramid-shaped end portion 110 and processed into a flat portion 120 including a flat surface 125 supporting the single end portion 110.

In the contact tip forming step S400, a side surface of the contact member may be processed to determine the cross-sectional area or outer diameter of the flat portion 120. Furthermore, the side surface of the contact member may be processed to determine the cross-sectional area or outer diameter of the body portion 130.

As illustrated in FIG. 3b, a first line L1 may be located outside a second line L2. On the other hand, the first line L1 may be located in the same position as the second line L2 (see FIG. 4b), or the first line L1 may be located inside the second line L2 (see FIG. 4c).

As described above, the flat portion 120 includes a first portion 121 and a second portion 122 having different cross-sectional areas or outer diameters. Furthermore, as described above, the flat portion 120 may be formed in a single shape with the same cross-sectional area or outer diameter.

Referring to FIG. 3c, a single end portion 110 may be formed on a flat portion 120. Here, the end portion 110 may have a cone shape.

In the end portion forming step S200 and the flat portion forming step S300, a contact member may be cut and processed into a single cone-shaped end portion 110 and processed into a flat portion 120 including a flat surface 125 supporting the single end portion 110.

In the contact tip forming step, the side surface of the contact member may be processed to determine the cross-sectional area or outer diameter of the flat portion 120. Furthermore, the side surface of the contact member may be processed to determine the cross-sectional area or outer diameter of the body portion 130.

As illustrated in FIG. 3c, a first line L1 may be located outside a second line L2. On the other hand, the first line L1 may be located in the same position as the second line L2 (see FIG. 4b), or the first line L1 may be located inside the second line L2 (see FIG. 4c).

As described above, the flat portion 120 includes a first portion 121 and a second portion 122 having different cross-sectional areas or outer diameters. Furthermore, as described above, the flat portion 120 may be formed in a single shape with the same cross-sectional area or outer diameter.

Referring to FIG. 4a, a plurality of end portions 110 may be formed on a flat portion 120. Here, the end portions 110 may have a square pyramid shape. However, the shape of the end portions 110 is not limited to that described above.

A contact tip 100 according to an embodiment of the present disclosure may include a plurality of end portions 110, a flat portion 120, and a body portion 130. The plurality of end portions 110 may be spaced apart from an edge of a flat surface 125 in the central axis direction.

In the end portion forming step S200 and the flat portion forming step S300, a contact member may be cut and processed into a plurality of square pyramid-shaped end portions 110 and processed into a flat portion 120 including a flat surface 125 supporting the plurality of end portions 110.

In the contact tip forming step S400, a side surface of the contact member may be processed to determine the cross-sectional area or outer diameter of the flat portion 120. Furthermore, the side surface of the contact member may be processed to determine the cross-sectional area or outer diameter of the body portion 130.

The edge of the flat surface 125 of the flat portion 120 may be spaced apart from the plurality of end portions 110. That is, an empty space may be formed between the edge of the flat surface 125 and the closest point of each end portion 110.

As illustrated in FIG. 4a, a first line L1 may be located outside a second line L2. On the other hand, the first line L1 may be located in the same position as the second line L2 (see FIG. 4b), or the first line L1 may be located inside the second line L2 (see FIG. 4c).

As described above, the flat portion 120 includes a first portion 121 and a second portion 122 having different cross-sectional areas or outer diameters. Furthermore, as described above, the flat portion 120 may be formed in a single shape with the same cross-sectional area or outer diameter.

Referring to FIG. 4b, a plurality of end portions 110 may be formed on a flat portion 120. Here, the end portions 110 may have a square pyramid shape. However, the shape of the end portions 110 is not limited to that described above.

A contact tip 100 according to an embodiment of the present disclosure may include a plurality of end portions 110, a flat portion 120, and a body portion 130. The plurality of end portions 110 may be in contact with an edge of a flat surface 125.

In the contact tip forming step S400, a side surface of the contact member may be processed to determine the cross-sectional area or outer diameter of the flat portion 120. Furthermore, the side surface of the contact member may be processed to determine the cross-sectional area or outer diameter of the body portion 130.

The edge of the flat surface 125 of the flat portion 120 may be in contact with the plurality of end portions 110. That is, the edge of the flat surface 125 may be in contact with the closest point of each end portion 110.

As illustrated in FIG. 4b, a first line L1 may be located in the same position as a second line L2. On the other hand, the first line L1 may be located outside the second line L2 (see FIG. 4a), or the first line L1 may be located inside the second line L2 (see FIG. 4c).

As described above, the flat portion 120 includes a first portion 121 and a second portion 122 having different cross-sectional areas or outer diameters. Furthermore, as described above, the flat portion 120 may be formed in a single shape with the same cross-sectional area or outer diameter.

Referring to FIG. 4c, a plurality of end portions 110 may be formed on a flat portion 120. Here, the end portions 110 may have a shape in which a part thereof is removed from an original square pyramid shape. However, the original shape before the part is removed is not limited to a square pyramid. The original shape may be at least one of a square pyramid, a triangular pyramid, and a cone, but is not limited thereto.

A contact tip 100 according to an embodiment of the present disclosure may include a plurality of end portions 110, a flat portion 120, and a body portion 130. The plurality of end portions 110 may each have a shape in which a part thereof is removed. The part may be an area including one vertex.

In the end portion forming step S200 and the flat portion forming step S300, a contact member may be cut and processed into a plurality of square pyramid-shaped end portions 110 and processed into a flat portion 120 including a flat surface 125 supporting the plurality of end portions 110.

In the contact tip forming step S400, a side surface of the contact member may be processed to determine the cross-sectional area or outer diameter of the flat portion 120. The side surface of the contact member may be processed to the end portions 110 to remove a part of each of the end portions 110. Specifically, the part of the end portion 110 may be an area including one vertex among a plurality of vertices constituting a bottom surface of the end portion 110.

Furthermore, the side surface of the contact member may be processed to determine the cross-sectional area or outer diameter of the body portion 130.

As illustrated in FIG. 4c, a first line L1 may be located inside a second line L2. On the other hand, the first line L1 may be located outside the second line L2 (see FIG. 4a), or the first line L1 may be located in the same position as the second line L2 (see FIG. 4b).

The flat portion 120 may be formed in a single shape with the same cross-sectional area or outer diameter. Furthermore, as described above, the flat portion 120 may be formed by dividing into a first portion 121 and a second portion 122 having different cross-sectional areas or outer diameters.

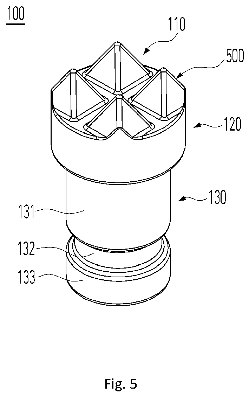

FIG. 5 is a view illustrating a plated contact tip 100 in an embodiment of the present disclosure.

Referring to FIG. 5, the method for manufacturing the contact tip according to the embodiment of the present disclosure may further include a plating layer forming step S500 of forming a plating layer 500 on the contact tip 100.

The contact tip 100 including the end portion 110, the flat portion 120, and the body portion 130 may be formed through the end portion forming step S200, the flat portion forming step S300, and the contact tip forming step S400. The plating layer 500 may be formed on the formed contact tip 100 to improve the electrical conductivity of the contact tip 100.

The plating layer 500 may include Au. The contact member may include at least one of NiB, NiP, and BeCu, but is not limited thereto.

Since the method for manufacturing the contact tip according to the embodiment of the present disclosure forms the contact tip 100 and the end portion 110 by cutting the contact member before processing, the contact tip 100 and the end portion 110 may be formed in various shapes without limitation.

In the method for manufacturing the contact tip according to the embodiment of the present disclosure, the relative positions of the first line L1 and the second line L2 may be freely set by cutting the side surface of the contact member.

The method for manufacturing the contact tip according to the embodiment of the present disclosure may manufacture a contact tip 100 having various shapes by varying the number of end portions 110, the length of the edges constituting the end portion 110, the angle of the side surface, and the like.

The method for manufacturing the contact tip according to the embodiment of the present disclosure may provide the contact tip 100 more quickly by omitting a PR application process, an exposure process, and a plating process that are repeated in an MEMS process.

Since the electroconductive pin 10 having the contact tip 100 according to the embodiment of the present disclosure is manufactured by cutting the contact tip 100, it is possible to manufacture an electroconductive pin 10 of various shapes by easily responding to consumer requests.

Although the preferred embodiment of the present disclosure has been disclosed for illustrative purposes, those skilled in the art will appreciate that various modifications, additions, and substitutions are possible, without departing from the scope and spirit of the present disclosure as disclosed in the accompanying claims.

### [Description of the Reference Numerals in the Drawings]

10: electroconductive pin
100: contact tip
110 : end portion
120: flat portion
121: first portion
122: second portion
125: flat surface
130: body portion
131: first body portion
132: second body portion
133: third body portion
134: fourth body portion
135 : first step
136 : second step
200: barrel part
201: hollow
210: first separation preventing portion
220: second separation preventing portion
230: fixing portion
300: moving tip
310: moving end portion
320: moving body portion
400: elastic part
500: plating layer

## Claims

1. A method for manufacturing a contact tip used for an electroconductive pin for inspecting electrical properties of an inspection object, the method comprising:
a preparation step of preparing a contact member to be processed;
an end portion forming step of forming an end portion by cutting a longitudinal surface of the contact member;
a flat portion forming step of cutting the longitudinal surface to form a flat surface to which the end portion is connected; and
a contact tip forming step of forming an exterior of a contact tip by processing a side surface of the contact member.

2. The method of claim 1, wherein in the end portion forming step, surfaces constituting the end portion are subjected to mirror surface finishing.

3. The method of claim 1, wherein in the end portion forming step, the end portion is formed in the shape of a pyramid or cone.

4. The method of claim 1, wherein in the end portion forming step, the end portion comprises a plurality of end portions, wherein each end portion has a pyramid shape, and each end portion is formed so that at least one vertex thereof is in contact with an edge of the flat portion.

5. The method of claim 1, wherein in the end portion forming step, the end portion comprises a plurality of end portions spaced apart from each other.

6. The method of claim 1, wherein in the contact tip forming step, a side surface of the flat portion is processed so that an edge of the flat surface makes contact with the contact tip.

7. The method of claim 1, wherein in the contact tip forming step, a side surface of the flat portion is processed to remove a part of the contact tip on the flat surface.

8. The method of claim 1, further comprising:
a plating layer forming step of forming a plating layer on the contact tip.

9. An electroconductive pin, comprising:
a contact tip manufactured by the method according to claim 1;
a barrel part having a side connected to the contact tip;
an elastic part located in a hollow of the barrel part and having a side supported by the contact tip; and
a moving tip moved in a longitudinal direction in conjunction with compression and extension of the elastic part.

10. The electroconductive pin of claim 9, wherein the contact tip comprises a single triangular pyramid-shaped end portion.

11. The electroconductive pin of claim 9, wherein the contact tip comprises a plurality of square pyramid-shaped end portions and a flat surface on which the plurality of end portions are formed,
wherein an edge of the flat surface is in contact with the plurality of end portions.

12. The electroconductive pin of claim 9, wherein the contact tip comprises an end portion having a shape in which one vertex area is removed from a square pyramid shape and a flat surface on which the end portion is formed.
